Europäisches Patentamt

European Patent Office

Office européen des brevets

(11) Publication number: **0 175 604 B1**

(12) **EUROPEAN PATENT SPECIFICATION**

(45) Date of publication of patent specification: **19.07.89**

(51) Int. Cl.⁴: **H 01 L 21/90**

(21) Application number: **85401638.3**

(22) Date of filing: **13.08.85**

(54) A process for forming vias on integrated circuits.

(30) Priority: **23.08.84 US 644028**

(43) Date of publication of application:
**26.03.86 Bulletin 86/13**

(45) Publication of the grant of the patent:
**19.07.89 Bulletin 89/29**

(84) Designated Contracting States:
**DE FR GB IT NL**

(56) References cited:
**EP-A-0 129 389**
**US-A-4 410 622**

**IBM TECHNICAL DISCLOSURE BULLETIN, vol.
19, no. 9, February 1977, pages 3364-3365, New
York, US; W.C. METZGER et al.: "Forming
planar integrated circuit metallization"**
**JOURNAL OF THE ELECTROCHEMICAL
SOCIETY, vol. 131, no. 1, January 1984, pages
115-120, Manchester, US; C.C. TANG et al.:
"Tungsten etching in CF4 and SF6 discharges"**

(73) Proprietor: **FAIRCHILD SEMICONDUCTOR
CORPORATION**
**10400 Ridgeview Court P.O. Box 1500**
**Cupertino, California 95014 (US)**

(72) Inventor: **Thomas, Michael E.**
**20718 Garden Ct.**
**Cupertino California 95014 (US)**
Inventor: **Brown, Robert L.**
**11928 Cooley Avenue**
**E. Palo Alto California 94303 (US)**

(74) Representative: **Dipl.-Ing. H. Marsch Dipl.-Ing. K.
Sparing Dipl.-Phys.Dr. W.H. Röhl Patentanwälte
Rethelstrasse 123 Postfach 14 02 68
D-4000 Düsseldorf (DE)**

Courier Press, Leamington Spa, England.

## Description

This invention is related to the fabrication of multi-level integrated circuits and more particularly to the formation of vias for selectively providing electrical interconnections between selected levels of the multi-level structure.

Integrated circuits include a multiplicity of semiconductor devices which are disposed substantially co-planar with respect to one another on a silicon wafer. In order to have a functioning circuit, it is necessary to electrically interconnect these devices. Electrical interconnections depending on the complexity of the circuit, may require duplication of devices, extensive or complex routing of the interconnects, or both. Such requirements adversely affect circuit densification by utilizing more area than would be necessary if the interconnects were able to be routed without consideration of overlapping metal lines.

It is of course possible to route interconnects over one another without making contact by constructing multi-level integrated circuit devices comprising two or more levels of interconnects separated by a dielectric layer. When constructing such devices, vertical interconnects, sometimes known as vias, are required in order to route signals and signal returns from one level of planar interconnects to another.

As device densification on the integrated circuits becomes greater, alignment of vias becomes more and more critical. This is due to the fact that the greater device density necessarily causes a concomitant increase in contact and interconnect density. Consequently, when it is required to electrically connect a particular contact or interconnect disposed on the substrate to a particular interconnect on the next higher level or to electrically connect two particular interconnects between levels, precise alignment of the vias is mandatory. Misalignment could cause unwanted short circuits between interconnects or between a contact and an interconnect.

In addition to short circuits, a misalignment may also create a marginal electrical contact between the via and the interconnect thereby creating a region of increased current density, a defect which can be potentially fatal to the operation of the circuit. Furthermore, utilizing the prior art technique of via formation which entails deposition of the via material into an aperture etched through the dielectric material separating the interconnect levels, misalignment of the via apertures may cause over etching of the dielectric down to the proximity of the surface of the semiconductor substrate, if not actually into the substrate. Subsequent deposition of the via metal into the aperture could then create defects due to punch through or contamination of the substrate material.

One method of compensating for via misalignment consists of forming pads or nests which are enlargements of the width of the planar interconnects at the approximate via locations. Consequently, the larger the pad or nest, the greater the via misalignment which can be tolerated.

Creation of such pads or nests itself has an adverse affect on densification since these enlarged portions of the interconnect preclude closer spacing between interconnects.

Accordingly, it is an object of the present invention to provide a method for forming vertical interconnects in multi-layer integrated circuits which are substantially self aligning.

Another object of the present invention is to provide a method of forming vertical interconnects in a multi-layer integrated circuit which permits enhanced densification of devices within the circuit.

It is a further object of the present invention to provide a method for forming vertical interconnects between levels of a multi-level integrated circuit which enhances the reliability of the vertical connection.

It is yet another object of the present invention to provide a method for forming vertical interconnects between levels of a multi-level integrated circuit while minimizing defects caused by via misalignment.

## Summary of the invention

In accordance with the present invention, a layer of a first metal, which is reactive to a first etchant and not a second etchant, is formed on a semiconductor substrate. A layer of a second metal, which is reactive to the second etchant but not the first etchant, is formed on the first metal layer. The second metal layer is then masked as required to form the desired number of vias in predetermined locations as required by the preselected interconnect pattern. The vias are then formed by etching back the unmasked portions of the second metal layer. Since the first metal layer is not reactive to the second etchant, etching will stop at the surface of the first metal layer. The first metal layer is then masked to form the desired interconnect pattern. The first metal layer is then etched using the first etchant. Since the second metal layer is non-reactive to the first etchant, the vias which were formed in the second metal layer are unaffected by the first etchant and furthermore serve as masks on the first metal layer thereby creating precise alignment between the vias constructed of the second metal with the interconnects constructed of the first metal.

## Brief description of the drawings

Figures 1A through 1H depict sequential cross-sectional views of one fabrication scheme for an integrated circuit employing a preferred embodiment of the method of the present invention.

Figure 2 is a top plan view of a segment of an integrated circuit as depicted in cross-section in Figure 1D.

Figure 3 is a top plan view of an integrated circuit as depicted in cross-section in Figure 1F.

Figures 4A through 4G illustrate sequential cross-sectional views of another fabrication scheme for an integrated circuit employing an alternate preferred embodiment of the method of the present invention.

## Description of the preferred embodiments

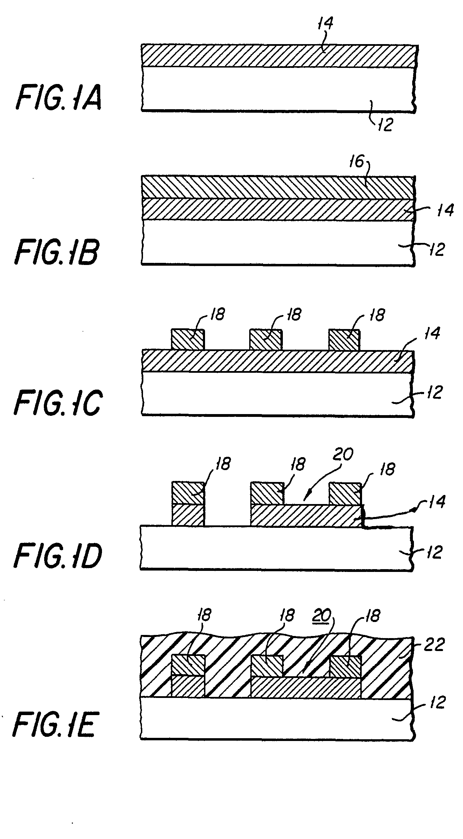

Referring to Figure 1A, there is shown a substrate 12 having a first layer 14 of a first metal formed thereon by conventional means such as sputtering, physical vapor deposition (PVD), or chemical vapor deposition (CVD). Although the first metal may be any metal which conducts electricity and which reacts with at least one etchant and the thickness of this first layer 14 may range from tens of nanometers (hundreds of angstroms) to ten micrometers or more; in the preferred embodiment, the first metal 14 is either tungsten or aluminum and the thickness of the layer is substantially equal to 750 nm (7,500 Å). As shown in Figure 1B, a second layer 16 of a second metal is formed on the first layer 14 by conventional means such as sputtering, PVD, or CVD. Although the second metal may be any metal which conducts electricity and which does not react in any substantial manner with that etchant which reacts with the first metal; it is preferred that the second metal be aluminum if the first metal is tungsten or that the second metal be tungsten if the first metal is aluminum. Furthermore, although the thickness of this second layer 16 may range from tens of nanometers (hundreds of angstroms) to ten micrometers or more; it is preferred that the second layer have a thickness typically equal to the first metal layer. Consequently, in the preferred embodiment, the thickness of the second layer 16 is substantially equal to 750 nm (7,500 Å).

Following the formation of the second metal layer 16 on the first metal layer 14, the second metal layer 16 is masked, using conventional photoresist techniques, in order to define a desired pattern of vertical posts or vias in the second metal layer 16. After the desired via pattern is formed the second metal layer 16 is then etched, using an etchant which reacts with the second metal and not with the first metal in any substantial manner. Preferably, an anisotropic etch process is used to define these structures. Where the second metal is aluminum and the first metal is tungsten, a chlorine based dry etchant is utilized. Where the second metal layer is tungsten and the first metal layer is aluminum, a fluorine based dry etchant is utilized. The photoresist mask allows the etching process to produce a pattern of vias in accordance with the predetermined masked pattern. Since the first metal does not react with the second etchant, the etching process stops at the upper surface of the first metal layer 14.

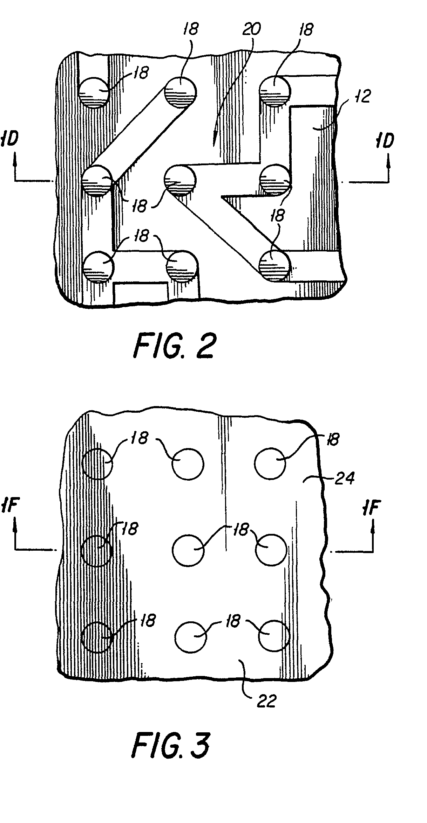

Following the formation of the vias 18, and removal of the photoresist used to define them, a second layer of a photoresist material is disposed on the first metal layer 14 and defined pattern of via posts. The photoresist is then exposed in accordance with a predetermined interconnect pattern. The exposed photoresist pattern masks the first metal layer 14 against the first etchant in accordance with conventional photoresist etching procedures. The unprotected regions of the first metal layer 14 are then etched with the first etchant which selectively removes the first metal while not affecting the vias 18 which are formed of the second metal. Consequently, the first metal layer 14 is etched around the photoresist mask pattern as well as around the vias 18 down to the substrate 12, thereby forming the desired interconnect pattern 20 with the vias 18 disposed thereon (see Figures 2 and 1D which is a sectional elevation view taken along line 1D—1D of Figure 2).

Since the vias 18 are unaffected by the first etchant, they act as masks which prevents the first etchant from etching the first metal disposed immediately underneath the vias. Consequently, it can be seen that even if the vias are misaligned with respect to the interconnect pattern, the interconnects will automatically be extended to coincide with the boundaries of the misaligned via thereby creating a contact area which is substantially coextensive with the bottom surface area of each via.

If the vias were formed through apertures which are created by non-selective etching through the dielectric layer and not properly aligned, it is quite possible that the dielectric could be etched down through the misaligned area possibly as far as the subtrate. In this case, the via hole would expose the substrate to subsequent metal deposition which could catastrophically affect the device. Even if the etch does not expose the substrate, there still remains the possibility of dielectric failure by electrical breakdown and poor metal step coverage into this region.

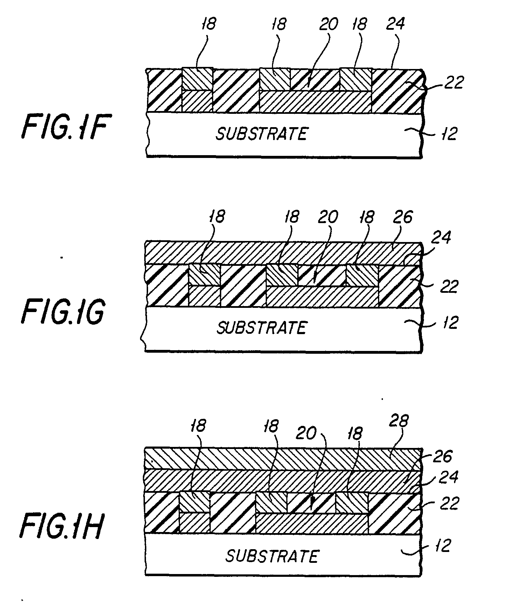

After formation of the vias 18 on the desired interconnect pattern 20, a layer of dielectric 22 is formed on the substrate 12, covering the interconnects 20 and the vias 18, as shown in Figures 3 and 1F which is a cross-section of Figure 3 taken along lines 1F—1F. The dielectric layer preferably comprises silicon dioxide and is formed by CVD or sputtering to a thickness typically equal to 2 microns. The dielectric layer 22 is then etched back to form a substantially planar surface 24 which exposes the tops of the vias 18. The dielectric etchant is typically fluorine based which has a suitable selectivity of the dielectric over the via metal. The dielectric etchant may even react with the via post metal as long as the dielectric etch rate is greater than or equal to the etch rate of the via post metal. A third layer 26 of the first metal is formed on the surface 24 as shown in Figure 1G. The third layer 26 is formed by conventional deposition techniques such as PVD or CVD and has a thickness typically equal to 750 nm (7,500 Å). As shown in Figure 1H, a fourth layer 28 of the second metal is formed on the third layer 26 by the conventional metallization techniques described previously. The process used to generate the first set of interconnects and vias may be used to define a second set of interconnects and vias. The number of levels that can be generated by this method is substantially unlimited and can be used to contact metal layers at any level directly to the substrate by building via posts from the substrate to any desired metal layer.

The final interconnect level can be constructed by forming a single layer of the first metal over the exposed top surfaces of the underlying vias which layer is then etched in accordance with a predetermined pattern exposed in a layer of photoresist as is known in the art. This final level can then be coated with a dielectric for scratch protection in the conventional manner in order to complete the multi-level structure.

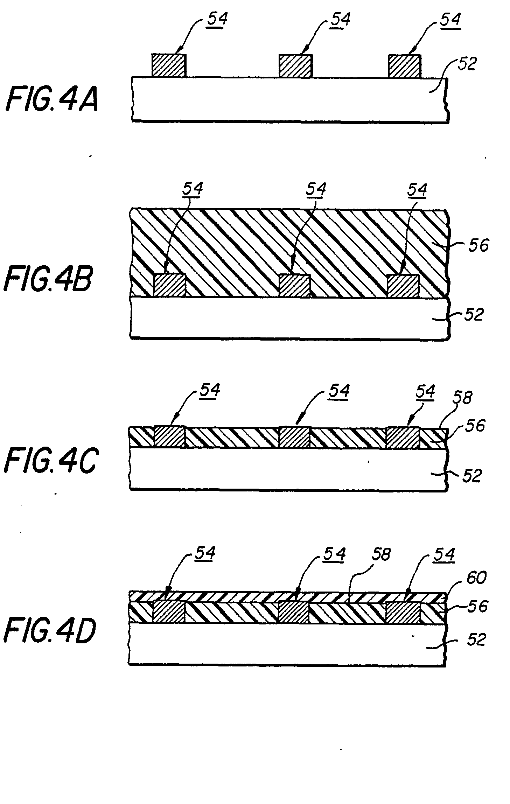

Referring now to Figures 4A through 4G, there is shown another fabrication scheme for multi-level integrated circuits employing an alternate preferred embodiment of the method of the present invention. Figure 4A shows a substrate 52 having a predetermined interconnect pattern 54 formed on an upper surface thereof. The interconnects are electrically conductive and preferably constructed of aluminum alloys or refractory metals and are formed in the predetermined pattern using conventional mask and photoresist techniques. As shown in Figure 4B, a layer of thermal nitride 56 is formed on the upper surface of the substrate 52 over the patterned metal features 54. It is preferred that this thermal nitride be silicon nitride which is formed by conventional deposition techniques to a thickness which is typically equal to 2000 nm (20,000 Å). The nitride is planarized as shown in Figure 4C using an etchback planarization process.

Next, as shown in Figure 4D, a dielectric layer 60 is formed on the surface 58 of the thermal nitride layer 56 over the exposed tops of the metal topography 54. It is preferred that the dielectric layer 60 comprise a silicon dioxide material which is formed to a thickness of approximately 300—1,500 nm (3,000—15,000 Å) using conventional deposition techniques. The preferred range of thickness for layer 54 is 300—500 nm (3,000 Å—5,000 Å).

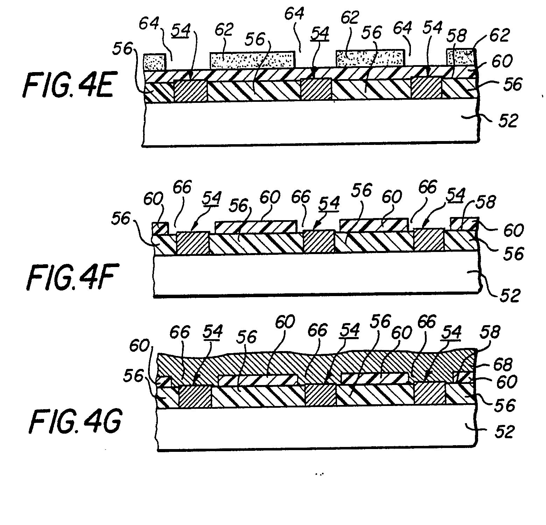

Next, as shown in Figure 4E, a layer of photoresist material 62 is formed on the dielectric layer 60 and is masked and patterned using conventional photoresist techniques to form a plurality of via apertures 64. The silicon dioxide layer 60 is etched through the aperture 64 down to the top surface of the metal topography 54 and the surface 58 of the thermal nitride layer 56 using a conventional wet etch technique and an etching solution, preferably an HF bearing solution, which will etch through the silicon dioxide layer but will stop on the metal and nitride layers. As a result of this etching step, via apertures 66 are formed through the silicon dioxide layer 60 down to the upper surface of the metal topography 54 and the upper surface 58 of the thermal nitride layer 56, as shown in Figure 4F. Also this second dielectric enhances device reliability by filling in any pinholes in the film.

Next, it is preferred that the exposed metal contacts of the metal topography 54 be lightly sputter etched, preferably on the order of ten seconds, to ensure the creation of clean contact openings just prior to the deposition of the next metal layer. Next, as shown in Figure 4G, a metal layer 68 is formed over the silicon dioxide layer 60 and into the via apertures 66, by conventional deposition techniques. It is preferred that the metal layer 68 be comprised of aluminum or aluminum alloys and be formed to a thickness substantially equal to 800 nm (8,000 Å). This is then conventionally masked and etched to define the upper layer of interconnections.

As can be seen from the above description of the alternate preferred embodiment of the process of the present invention, it is not necessary to have the via apertures precisely aligned with respect to the underlying metal topography since the etchant used to create the apertures through the dielectric layer reacts only with this layer and not with the silicon nitride layer or the metal in the metal topography itself. As a result, even if the via apertures 66 are misaligned, the etching will stop on the metal and silicon nitride surfaces thereby preventing defects due to over etching as previously set forth with respect to the other preferred embodiment. Furthermore, using this alternate preferred embodiment of the process, it is not necessary to ensure that the via apertures are smaller than the underlying metal topography as was required in the prior art. Once again this is due to the use of a selective etchant and the appropriate materials as set forth in the aforementioned description whereby the etching process stops at the metal and silicon nitride surfaces and does not continue down past the metal topography through the overhang created by the enlarged via apertures 66 past the underlying metal topography 54.

While the principles of the present invention have now been made clear in an illustrative embodiment, there will be immediately obvious to those skilled in the art many modifications of structure, arrangement, the elements, material and components used in the practice of the invention and otherwise, which are particularly adapted for specific environments and operating requirements without departing from those principles. The appended claims are, therefore, intended to cover and embrace any such modifications within the limits only of the scope of the invention.

## Claims

1. A process for forming vias in an integrated circuit, said process comprising the steps of:

(a) forming a layer of a first metal (14) on a semiconductor substrate (12);

(b) forming a layer of a second metal (16) on said first metal layer;

(c) etching said second metal layer (16) in a predetermined via pattern with a second etchant which reacts with said second metal and which is substantially unreactive with said first metal; and

(d) forming said vias in predetermined spacial relationship with a predetermined interconnect pattern by etching said first metal layer (14), in said predetermined interconnect pattern, with a first etchant which reacts with said first metal and which is substantially unreactive with said second metal or with said semiconductor substrate.

2. The process in accordance with Claim 1, characterized in that said first metal comprises tungsten, said first etchant comprises a fluorine based dry etchant, said second metal comprises aluminum and said second etchant comprises a chlorine base dry etchant.

3. The process in accordance with Claim 1, characterized in that said first metal comprises aluminum, said first etchant comprises a chlorine based dry etchant, said second metal comprises tungsten and said second etchant comprises a fluorine based dry etchant.

4. The process in accordance with Claim 1, characterized by additionally comprising the steps of:

(e) forming a first dielectric layer (22) on said semiconductor substrate over said interconnects (20) and said vias (18); and

(f) forming a substantially planar surface on said first dielectric layer, which surface is substantially co-planar with the upper surfaces of said vias, by etching back said dielectric layer (22) using an etchant which reacts with said dielectric material at an etch rate which is greater than the etch rate at which said etchant reacts with said second metal.

5. The process in accordance with Claim 4, characterized in that said first dielectric layer comprises silicon dioxide and said etchant comprises a fluorine based etchant.

6. The process in accordance with Claim 4, characterized in that steps (a) through (f) are repeated at least once to form at least a second set of vias and at least a second predetermined interconnect pattern.

7. The process in accordance with any one of Claims 4 to 6, characterized by additionally comprising the steps of:

(g) forming a third layer of said first metal (26) on said planar surface;

(h) etching said third layer in a second predetermined interconnect pattern; and

(i) forming a layer of dielectric material over said second predetermined interconnect pattern and said first dielectric layer.

8. A process for fabricating a multi-level integrated circuit, said process comprising the steps of:

(a) forming a first layer of metal on a semiconductor substrate (52);

(b) forming a first level of interconnects (54) in said first metal layer in a first predetermined pattern;

(c) forming a layer of a first dielectric material (56) on said semiconductor substrate over said first level of interconnects;

(d) forming a substantially planar surface (58) on said first dielectric layer, which surface is substantially co-planar with the upper surfaces of said first level of interconnects (54), by etching back said dielectric layer (56) using an etchant which reacts with said dielectric material and not with the interconnect material;

(e) forming a layer of a second dielectric material (60) on said surface of said first dielectric material (56) over the upper surfaces of said first level interconnects;

(f) etching a predetermined pattern of via apertures (66) in said second dielectric layer (60), using an etchant which reacts with said second dielectric material and which is substantially unreactive with said first dielectric material and said first level interconnect material;

(g) forming a second layer of metal (68) over said second dielectric material (60), which layer of metal extends into said via apertures (66) and contacts the upper surfaces of said first level interconnects; and

(h) forming a second level of interconnects in said second metal layer in a second predetermined interconnect pattern having predetermined contacting relationship with said first level of interconnects through said via apertures.

9. The process in accordance with Claim 8, characterized by additionally comprising the step of forming a layer of dielectric material over said second predetermined interconnect pattern and said second dielectric material.

10. The process in accordance with Claim 8 characterized in that steps (c) through (h) are repeated at least once to form at least a third level of interconnects in predetermined contacting relationship with said second level of interconnects and additionally comprising the step of forming a top layer of dielectric material over said final level of interconnects.

**Patentansprüche**

1. Ein Verfahren für die Bildung von Kontaktlöchern in einem integrierten Schaltkreis, das die Schritte umfaßt:

(a) Bilden einer Schicht eines ersten Metalls (14) auf einem Halbleitersubstrat (12);

(b) Bilden einer Schicht eines zweiten Metalls (16) auf der genannten ersten Metallschicht;

(c) Ätzen der genannten zweiten Metallschicht (16) in einem vorgegebenen Kontaktlochmuster mit einem zweiten Ätzmittel, das mit dem zweiten Metall reagiert und im wesentlichen nicht reaktiv ist mit dem genannten ersten Metall und

(d) Bildung der genannten Kontaktlöcher in einem vorgegebenen räumlichen Verhältnis mit einem vorgegebenen Verbindungsmuster durch Ätzen der genannten ersten Metallschicht (14) in dem genannten vorgegebenen Verbindungsmuster mit einem ersten Ätzmittel, das mit dem genannten ersten Metall reagiert und im wesentlichen nicht reaktiv ist mit dem genannten zweiten Metall oder mit dem genannten Halbleitersubstrat.

2. Das Verfahren nach Anspruch 1, dadurch gekennzeichnet, daß das genannte erste Metall Wolfram umfaßt, daß das genannte erste Ätzmittel ein Trockenätzmittel auf Fluorbasis ist, daß das genannte zweite Metall Aluminium umfaßt und daß das genannte zweite Ätzmittel ein Trockenätzmittel auf Chlorbasis umfaßt.

3. Das Verfahren nach Anspruch 1, dadurch gekennzeichnet, daß das genannte erste Metall Aluminium umfaßt, daß das genannte erste Ätzmittel ein Trockenätzmittel auf Chlorbasis umfaßt, daß das genannte zweite Metall Wolfram umfaßt und daß das genannte zweite Ätzmittel ein Trockenätzmittel auf Fluorbasis umfaßt.

4. Das Verfahren nach Anspruch 1, zusätzlich gekennzeichnet durch die Schritte:

(e) Bilden einer ersten dielektrischen Schicht (22) auf dem Halbleitersubstrat über den genannten Verbindungen (20) und den genannten Kontaktlöchern (18), und

(f) Bilden einer im wesentlichen planaren Oberfläche auf der genannten ersten dielektrischen Schicht, welche Oberfläche im wesentlichen coplanar mit den oberen Oberflächen der Kontaktlöcher ist, durch Rückätzen der genannten dielektrischen Schicht 22 unter Verwendung eines Ätzmittels, das mit dem genannten dielektrischen Material mit einer Ätzrate reagiert, die größer ist als die Ätzrate, bei welcher das genannte Ätzmittel mit dem genannten zweiten Metall reagiert.

5. Das Verfahren nach Anspruch 4, dadurch gekennzeichnet, daß die erste dielektrische Schicht Siliciumdioxid umfaßt und daß das genannte Ätzmittel ein Ätzmittel auf Fluorbasis umfaßt.

6. Das Verfahren nach Anspruch 4, dadurch gekennzeichnet, daß die Schritte (a) bis (f) mindestens einmal wiederholt werden zur Ausbildung mindestens eines zweiten Satzes von Kontaktlöchern und mindestens eines zweiten vorgegebenen Verbindungsmusters.

7. Das Verfahren nach einem der Ansprüche 4 bis 6, gekennzeichnet durch die zusätzlichen Schritte:

(g) Bilden einer dritten Schicht des genannten ersten Metalls (26) auf der genannten planaren Oberfläche;

(h) Ätzen der genannten dritten Schicht in einem zweiten vorgegebenen Verbindungsmuster; und

(i) Bilden einer Schicht von dielektrischem Material über dem genannten zweiten vorgegebenen Verbindungsmuster und der genannten ersten dielektrischen Schicht.

8. Ein Verfahren für die Herstellung eines integrierten Mehrfachniveauschaltkreises, welches Verfahren die Schritte umfaßt:

(a) Bilden einer ersten Schicht aus Metall auf einem Halbleitersubstrat (52);

(b) Bilden eines ersten Niveaus von Verbindungen (54) in der genannten ersten Metallschicht in einem ersten vorgegebenen Muster,

(c) Bilden einer Schicht eines ersten dielektrischen Materials (56) auf dem genannten Halbleitersubstrat über dem genannten ersten Niveau von Verbindungen,

(d) Bilden einer im wesentlichen planaren Oberfläche (58) auf der genannten ersten dielektrischen Schicht, welche Oberfläche im wesentlichen coplanar mit den oberen Oberflächen des genannten ersten Niveaus von Verbindungen (54) ist, durch Rückätzen der genannten dielektrischen Schicht (56) unter Verwendung eines Ätzmittels, das mit dem genannten dielektrischen Material reagiert, nicht jedoch mit dem Verbindungsmaterial;

(e) Bilden einer Schicht eines zweiten dielektrischen Materials (60) auf der genannten Oberfläche des genannten ersten dielektrischen Materials (56) über den oberen Oberflächen des genannten ersten Verbindungsniveaus;

(f) Ätzen eines vorgegebenen Musters von Kontaktlöchern (66) in der genannten zweiten dielektrischen Schicht (60) unter Verwendung eines Ätzmittels, das mit dem genannten zweiten dielektrischen Material reagiert und im wesentlichen nicht reaktiv ist mit dem genannten ersten dielektrischen Material und dem Material des genannten ersten Verbindungsniveaus;

(g) Bilden einer zweiten Metallschicht (68) über dem genannten zweiten dielektrischen Material (60), welche Metallschicht sich in die genannten Kontaktlöcher (66) erstreckt und die oberen Oberflächen der Verbindungen des genannten ersten Niveaus kontaktiert; und

(h) Bilden eines zweiten Verbindungsniveaus in der genannten zweiten Metallschicht in einem zweiten vorgegebenen Verbindungsmuster mit vorgegebenem Kontaktierungsverhältnis mit dem genannten ersten Niveau von Verbindungen durch die genannten Kontaktlöcher hindurch.

9. Das Verfahren nach Anspruch 8, dadurch gekennzeichnet, daß es zusätzlich den Schritt der Bildung einer Schicht aus dielektrischem Material über dem genannten zweiten vorgegebenen Verbindungsmuster und dem genannten zweiten dielektrischen Material umfaßt.

10. Das Verfahren nach Anspruch 8, dadurch gekennzeichnet, daß die Schritte (c) bis (h) mindestens einmal wiederholt werden zur Bildung zumindest eines dritten Verbindungsniveaus in vorgegebenem Kontaktierungsverhältnis mit dem genannten zweiten Niveau von Verbindungen und zusätzlich den Schritt umfassend, eine Deckschicht aus dielektrischem Material über dem genannten letzten Niveau von Verbindungen auszubilden.

**Revendications**

1. Procédé de formation de passages de connexion dans un circuit intégré, ce procédé consistant:

(a) à former une couche d'un premier métal (14) sur un substrat semi-conducteur (12),

(b) à former une couche d'un second métal (16) sur ladite première couche métallique,

(c) à graver ladite seconde couche métallique (16) dans une configuration prédéterminée des passages de connexion avec un second produit d'attaque qui réagit avec ledit second métal et qui ne réagit pratiquement pas avec ledit premier métal, et

(d) à former lesdits passages de connexion dans une relation spatiale prédéterminée avec une configuration prédéterminée des interconnexions en gravant ladite première couche métallique (14) dans ladite configuration prédéterminée d'interconnexions avec un premier produit d'attaque qui réagit avec ledit premier métal et qui ne réagit pratiquement pas avec ledit second métal ni avec ledit substrat semi-conducteur.

2. Procédé selon la revendication 1, caractérisé en ce que ledit premier métal consiste en du tungstène, ledit premier produit d'attaque consistant en un produit d'attaque à sec à base de fluor, ledit second métal consistant en de l'aluminium et ledit second produit d'attaque consistant en un produit d'attaque à sec à base de chlore.

3. Procédé selon la revendication 1, caractérisé en ce que ledit premier métal consiste en de l'aluminium, ledit premier produit d'attaque consistant en un produit d'attaque à sec à base de chlore, ledit second métal consistant en du tungstène et ledit second produit d'attaque consistant en un produit d'attaque à sec à base de fluor.

4. Procédé selon la revendication 1, caractérisé en ce qu'il consiste en outre:

(e) à former une première couche diélectrique (22) sur ledit substrat semi-conducteur au-dessus desdites interconnexions (20) et desdits passages de connexion (18), et

(f) à former une surface pratiquement plane sur ladite première couche diélectrique, cette surface étant pratiquement coplanaire avec les surfaces supérieures desdits passages de connexion, en gravant en arrière ladite couche diélectrique (22), en utilisant un produit d'attaque qui réagit avec ladite matière diélectrique à une vitesse d'attaque qui est supérieure à la vitesse d'attaque à laquelle ledit produit d'attaque réagit avec ledit second métal.

5. Procédé selon la revendication 4, caractérisé en ce que ladite première couche diélectrique consiste en du dioxyde de silicium, ledit produit d'attaque consistant en un produit d'attaque à base de fluor.

6. Procédé selon la revendication 4, caractérisé en ce que les opérations (a) à (f) sont répétées au moins une fois pour former au moins un second ensemble de passages de connexion et au moins une seconde configuration prédéterminée des interconnexions.

7. Procédé selon l'une quelconque des revendications 4 à 6, caractérisé en ce qu'il consiste en outre:

(g) à former une troisième couche dudit premier métal (26) sur ladite surface plane,

(h) à graver ladite troisième couche dans une seconde configuration prédéterminée des interconnexions, et

(i) à former une couche de matière diélectrique au-dessus de ladite seconde configuration prédéterminée d'interconnexions et ladite première couche diélectrique.

8. Procédé de fabrication d'un circuit intégré à niveaux multiples, ce procédé consistant:

(a) à former une première couche de métal sur un substrat semi-conducteur (52),

(b) à former un premier niveau d'interconnexions (54) sur ladite première couche métallique, dans une première configuration prédéterminée,

(c) à former une couche d'une première matière diélectrique (56) sur ledit substrat semi-conducteur au-dessus du premier niveau d'interconnexions,

(d) à former une surface pratiquement plane (58) sur ladite première couche diélectrique, cette surface étant pratiquement coplanaire avec les surfaces supérieures dudit premier niveau d'interconnexions (54) pra gravure arrière de ladite couche diélectrique (56) en utilisant un produit d'attaque qui réagit avec ladite matière diélectrique et non avec la matière d'interconnexions.

(e) à former une couche d'une seconde matière diélectrique (60) sur ladite surface de ladite première matière diélectrique (56) au-dessus des surfaces supérieures desdites interconnexions de premier niveau,

(f) à graver une configuration prédéterminée d'ouvertures de passages de contact (66) dans ladite seconde couche diélectrique (60) en utilisant un produit d'attaque qui réagit avec ladite seconde matière diélectrique et qui ne réagit pratiquement pas avec ladite première matière diélectrique et ladite matière d'interconnexions de premier niveau,

(g) à former une seconde couche de métal (68) au-dessus de ladite seconde matière diélectrique (60) cette couche de métal s'étendant dans lesdites ouvertures de passages de contact (66) et venant en contact avec les surfaces supérieures desdites interconnexions de premier niveau, et

(h) à former un second niveau d'interconnexions dans ladite seconde couche métallique dans une—seconde configuration prédéterminée des interconnexions, ayant une relation de contact prédéterminée avec ledit premier niveau d'interconnexions à travers lesdites ouvertures de passages de connexion.

9. Procédé selon la revendication 8, caractérisé en ce qu'il consiste en outre à former une couche de matière diélectrique sur ladite seconde configuration prédéterminée d'interconnexions et ladite seconde matière diélectrique.

10. Procédé selon la revendication 8, caractérisé en ce que les opérations (c) à (h) sont répétées au moins une fois pour former au moins un troisième niveau d'interconnexions en relation de contact prédéterminée avec ledit second niveau d'interconnexions et consistant en outre à former une couche supérieure de matière diélectrique au-dessus dudit niveau final d'interconnexions.

FIG.1A

FIG.1B

FIG.1C

FIG.1D

FIG.1E

FIG.1F

FIG.1G

FIG.1H

FIG. 2

FIG. 3

54 54 54

52

*FIG.4A*

54 54 54

56

*FIG.4B*

52

54 54 54 58

56

*FIG.4C*

52

54 54 58 54 60

56

*FIG.4D*

52

FIG.4E

FIG.4F

FIG.4G